# EUROPEAN PATENT APPLICATION

(11) **EP 1 804 294 A1**
(43) Date of publication of application: **04.07.2007**
(21) Application number: 05425943.7
(22) Date of filing: 30.12.2005
(51) Int. Cl.: H01L 27/115, H01L 21/8247, H01L 21/28, H01L 29/788

(54) **Method for manufacturing non volatile memory cells**

(71) Applicant: STMicroelectronics S.r.l., 20041 Agrate Brianza (Milano) (IT)
(72) Inventor: Mariani, Marcello, 20059 Vimercate (Milano) (IT); Camerlenghi, Emilio, 24129 Bergamo (IT); Concari, Emanuele, 29017 Fiorenzuola d'Arda (Piacenza) (IT)
(74) Representative: Ferrari, Barbara

(57) **Abstract**

Method for manufacturing non volatile memory cells integrated on a semiconductor substrate (100), each one comprising a floating gate electrode (110), the method comprising the steps of:
- depositing at least one protective layer (30) on the semiconductor substrate (100),
- forming a first plurality of openings (40) in the protective layer (30),
- etching the semiconductor substrate (100) through the first plurality of openings (40) so as to form a plurality of trenches (60),
- filling in the plurality of trenches (60) and the first plurality of openings (40) by means of an insulation layer (70),
- etching surface portions of the protective layer (30) to form:
- surface portions (71) of the insulation layer (70) projecting from the semiconductor substrate (100) divided from each other by a second plurality of openings (72), and
- lower portions (31) of the protection layer (30) confined below the second plurality of openings (72),

- etching the insulation layer (70) to reduce the cross dimensions of the surface portions (71) of the insulation layer (70),
- removing the lower portions (31) of said protection layer (30) until the semiconductor substrate (100) is exposed.

## Description

### Field of application

The present invention relates to a method for manufacturing non volatile memory cells integrated on a semiconductor substrate.

More specifically, the invention relates to a method for manufacturing non volatile memory cells integrated on a semiconductor substrate, each one comprising a floating gate electrode, the method comprising the steps of:
- depositing at least one protective layer on said semiconductor substrate,
- forming a first plurality of openings in said protective layer,
- etching said semiconductor substrate through said first plurality of openings so as to form a plurality of trenches,
- filling in said plurality of trenches and said first plurality of openings by means of an insulation layer.

The invention relates, in particular but not exclusively, to a method for manufacturing non-volatile memory cells integrated in Flash memory electronic devices and the following description is made with reference to this field of application by way of illustration only.

### Prior art

As it is well known, non volatile memory electronic devices of the Flash type integrated on semiconductor comprise a plurality of non-volatile memory cells organised in matrix; i.e. the cells are organised in rows, called word lines, and columns, called bit lines.

Each single non volatile memory cell comprises a MOS transistor integrated on a semiconductor substrate wherein the so called gate electrode, arranged above the channel region, is floating, i.e. it has a high DC impedance towards all the other terminals of the same cell and of the circuit wherein the cell is inserted. The gate electrode is insulated from the semiconductor substrate, and thus from the channel region, at least by means of a dielectric layer called tunnel oxide.

The cell also comprises a second so called control gate electrode, which is driven by means of suitable control voltages. The other electrodes of the transistors are the usual drain, source terminals.

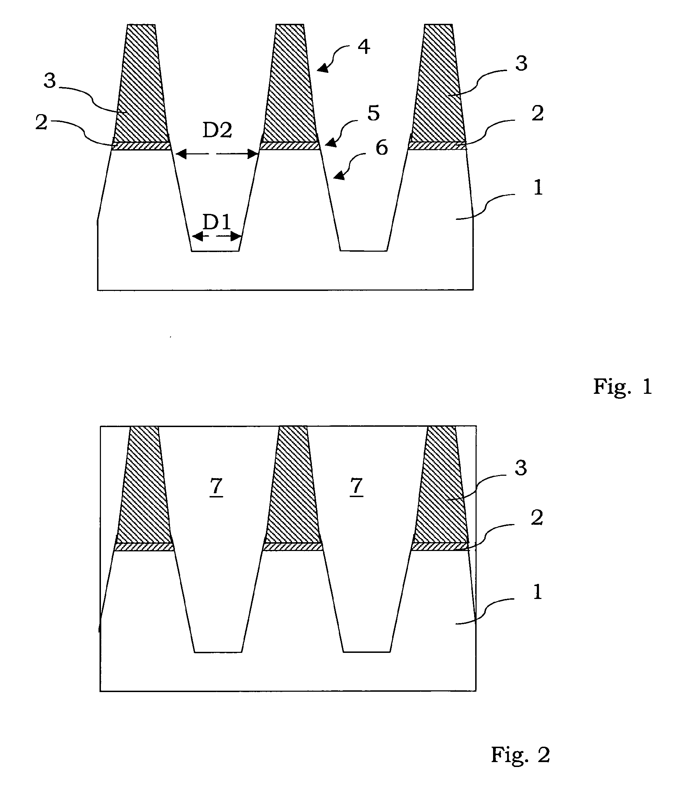

Some known process steps to form these Flash memories, i.e. provided with a floating gate electrode, organised in matrix are shown in figures 1-5. In these figures some vertical section views are shown of the memory cells in a direction parallel to the "Word Lines", but in a different plane respect to this latter so as to highlight the evolution of the standard process flow in these areas.

With reference to figure 1, on the semiconductor substrate 1 insulation structures of the STI type are formed.

For example, on the semiconductor substrate 1 a sacrificial oxide layer 2 and a nitride layer 3 are formed in sequence.

On the nitride layer 3 a photolithographic mask provided with openings is then formed.

Through the openings of the photolithographic mask, the nitride layer 3 is etched so as to form first openings 4. The walls of these openings 4 are vertical or tapered downwards, i.e. the width of the vertical section of the opening 4 is not constant and it decreases approaching the semiconductor substrate 1.

Through the first openings 4 of the nitride layer 3, the sacrificial oxide layer 2 is then etched so as to form second openings 5. The walls of these openings 5 are vertical or tapered downwards.

Through the second openings of the sacrificial oxide layer 2, surface portions of the semiconductor substrate 1 are etched to form trenches 6 in the semiconductor substrate 1. The side walls of the trenches 6 are tapered downwards of the device, i.e. the cross dimension D1 of the bottom wall of the trench 6 is smaller with respect to the cross dimension D2 of the lower edge of the second openings 5 of the sacrificial oxide layer 2.

As shown in figure 2, an oxide layer 7 called field oxide is then formed so as to fill in the trenches 6, the first and the second openings 4, 5.

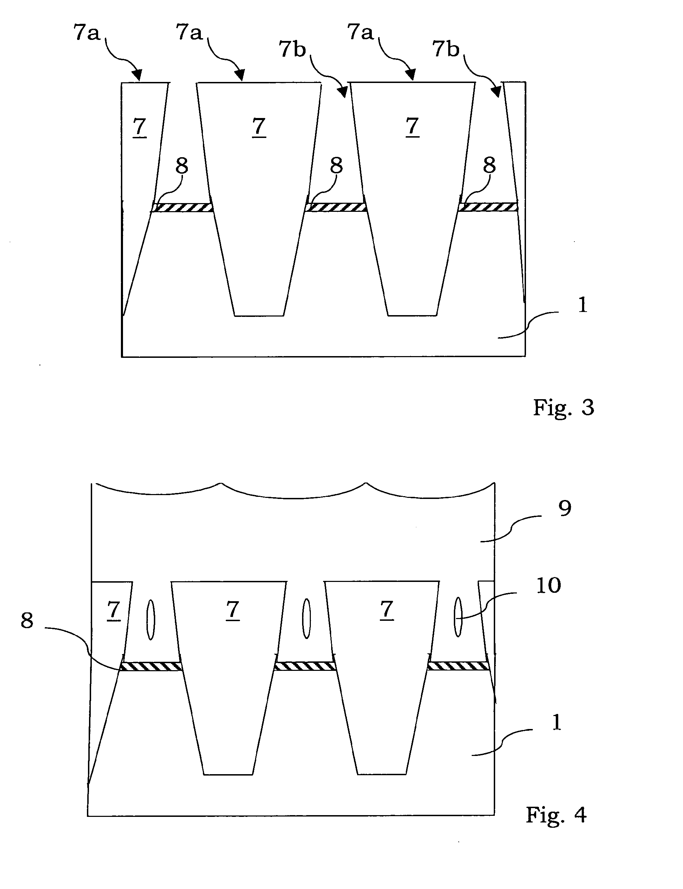

As shown in figure 3, the nitride layer 3 and the sacrificial oxide layer 2 are completely removed. Superficial portions 7a of the field oxide layer 7 then project from the semiconductor substrate 1 and are divided from each other by third openings 7b which have side walls being vertical with respect to the surface of the semiconductor substrate 1 or these side walls diverge approaching the semiconductor substrate 1. The third openings 7b have in fact the same shape as the one of the nitride layer 3 and of the sacrificial oxide layer 2 after the formation of the first and second openings 4, 5. Also the side walls of the surface portions 7a of the field oxide layer 7 are vertical or tapered downwards i.e. their cross dimensions decrease approaching the semiconductor substrate 1. In fact the walls of the surface portions 7a of the field oxide layer 7 follow the profile of the first and second openings 4 and 5, while the portions of the field oxide layer 7 formed inside the semiconductor substrate 1 follow the profile of the trench 6.

A so called tunnel oxide layer 8 is then formed on the exposed surface of the semiconductor substrate 1.

As shown in figure 4, a polysilicon layer 9 or amorphous silicon is then deposited on the whole device.

As it is well known polysilicon and amorphous silicon are conformal materials, i.e. they tend to follow the profile of the surface whereon they are deposited, therefore during the deposition step of the polysilicon layer 9, if the aspect ratio (ratio between the height and the width) of the third openings 7b is higher than 0.5:1, the deposition fronts formed on the side walls of the surface portions 7a of the field oxide layer 7, i.e. inside the third openings 7b, touch each other before the deposition front formed on the tunnel layer 8 can completely fill in the space comprised between adjacent surface portions 7a of the field oxide layer 7, thus forming voids 10 inside the polysilicon layer 9.

Therefore voids 10 are formed inside the polysilicon layer any time the cross dimensions of the third openings 7b are smaller than the double of their depth.

This drawback is also particularly evident when the side walls of the third openings 7a have a cross section which widens approaching the semiconductor substrate 1 as shown in figure 3.

The deposition of the polysilicon layer 9 is continued until the surface portions 7a of the field oxide layer 7 are completely covered.

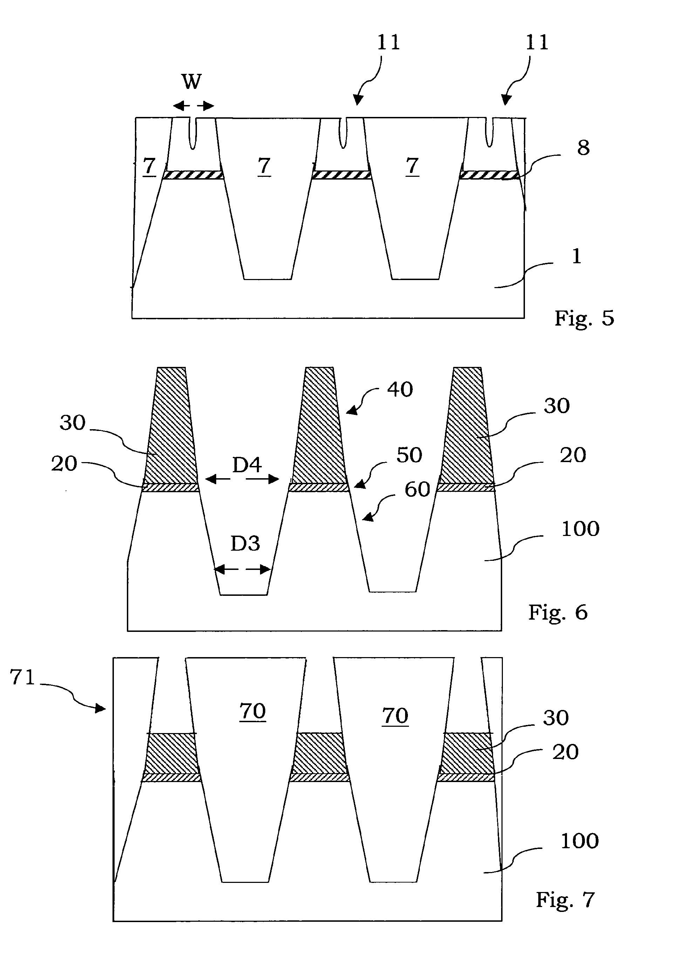

As shown in figure 5, a removal step of the polysilicon layer 9 is made follow at least until the surface portions 7a of the field oxide layer 7 are expose. Portions of the polysilicon layer 9 remaining confined between the surface portions 7a of the field oxide layer 7 form floating gate electrodes 11 of the Flash memory cells having width W.

This removal step of the polysilicon layer 9 is conventionally carried out by means of CMP (Chemical Mechanical Polishing).

The manufacturing process of the memory cells is then completed in a conventional way with the deposition, on the whole device, of an interpoly dielectric layer and a polysilicon layer for the formation of the control electrodes of the memory cells.

As highlighted in figure 5, during the formation step of the floating gate electrodes 11, the voids 10 are uncovered and widened, therefore an imperfect interface surface is formed with the successive interpoly dielectric layer deposited on the floating gate electrodes 11. This conformation of the floating gate electrodes 11 can thus generate retention problems of the electric charge of the final Flash memory cell, altering its operation.

However, it is quite difficult to modify the shape of the first and second openings 4, and 5 of the trenches 6 acting on the process steps leading to the formation of these structures, so as to obtain improved profiles of the field oxide layer which allow a uniform filling of the floating gate electrodes.

The technical problem underlying the present invention is that of devising a method for forming non volatile memory cells, having such characteristics as to allow to avoid the formation of voids inside the floating gate electrodes overcoming the drawbacks still limiting the memory devices formed according to the prior art.

### Summary of the invention

The solution idea underlying the present invention is that of reducing the cross dimensions of the insulation regions insulating the floating gate electrodes of the memory cells from each other.

On the basis of this solution idea the technical problem is solved by a method as previously indicated and defined in the characterising part of claim 1.

The characteristics and the advantages of the method according to the invention will be apparent from the following description of an embodiment thereof given by way of indicative and non limiting example with reference to the annexed drawings.

### Brief description of the drawings

In these drawings:
- figures 1 to 5 show section views of a semiconductor substrate portion during the conventional manufacturing steps of a memory device;
- figures 6 to 11 show section views of a semiconductor substrate portion during some manufacturing steps of a memory device according to the present invention.

### Detailed description

With reference to figures 6 to 11, a method is described for manufacturing non volatile memory cells integrated on a semiconductor substrate, each memory cell comprising a floating gate electrode.

Advantageously, these non-volatile memory cells are comprised in memory electronic devices of the Flash type and organised in matrix; i.e. the cells are organised in rows, called word lines, and columns, called bit lines.

For simplicity of description, figures 6 to 11 show vertical section views of these cells in a parallel direction "Word Lines" of a memory matrix wherein they can be integrated, but in a different plane respect to this latter so as to highlight the evolution of the standard process flow in these areas.

In particular, with reference to figure 6, on the semiconductor substrate 100 insulation structures of the STI type are formed.

On the semiconductor substrate 100 a sacrificial dielectric layer 20, for example of sacrificial oxide, and a protection layer 30, for example of nitride, are formed in sequence.

Nothing forbids that the sacrificial dielectric layer 20 is not formed on the semiconductor substrate 100.

On the protection layer 30 a photolithographic mask provided with openings is then formed.

Through the openings of the photolithographic mask, the protection layer 30 is etched so as to form first openings 40 whose walls are tapered downwards i.e. the width of the vertical section of each single opening 40 is not constant and it decreases approaching the semiconductor substrate 100.

Through the first openings 40 of the protection layer 30, the dielectric layer 20 is then etched so as to form second openings 50 whose walls are tapered downwards.

Through the second openings 50 of the dielectric layer 20, surface portions of the semiconductor substrate 100 are etched to form trenches 60 in the semiconductor substrate 100. Also the side walls of the trenches 60 are tapered downwards of the device, i.e. the cross dimension D3 of the bottom wall of the trench 60 is smaller with respect to the cross dimension D4 of the lower edge of the second openings 50 of the dielectric layer 20.

Although in the annexed figures the side walls are represented as perfectly rectilinear, these walls can also show a slight concavity or convexity, as well an irregular profile for example step-like.

An insulation layer 70, for example of field oxide, is then formed so as to fill in the trenches 60, the first and the second openings 40, 50.

According to the invention, as shown in figure 7, the protection layer 30 is only partially etched so that surface portions 71 of the insulation layer 70, project from the semiconductor substrate 1 separated from each other by third openings 72 and lower portions 31 of the protection layer 30 remain confined between the surface portions 71 of the insulation layer 70, below the third openings 72.

Also the bottom walls of the surface portions 71 of the insulation layer 70 are tapered downwards i.e. their cross dimensions decrease approaching the semiconductor substrate 100.

In particular, the etching step wherein the protection layer 30 is partially removed is very selective with respect to the insulation layer 70.

Advantageously, if the protection layer 30 is formed by one nitride layer, the etching step of this layer 30 comprises a solution of phosphoric acid (H₃PO₄).

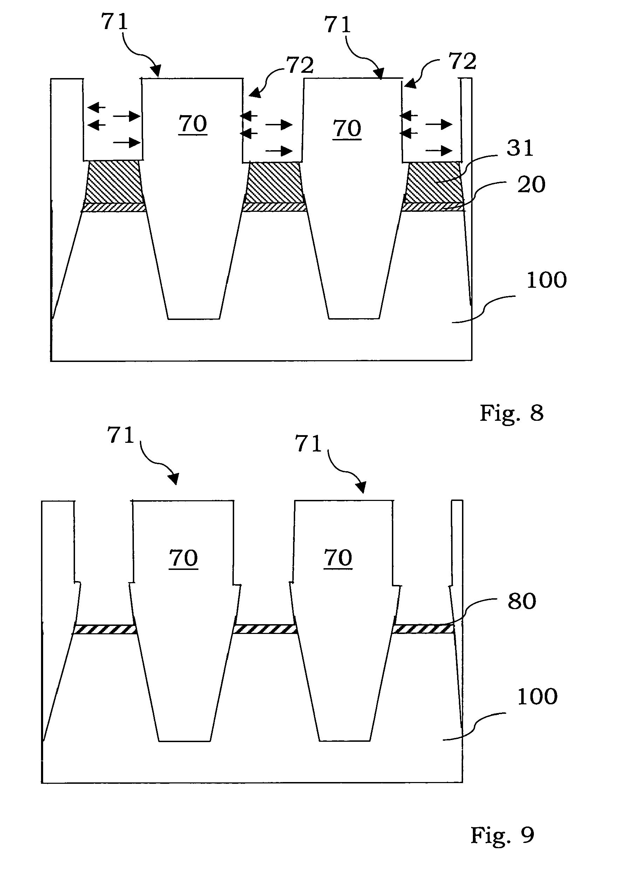

Still according to the invention, as shown in figure 8, an etching step of the insulation layer 70 is carried out. This etching step is very selective with respect to the lower portions 31 of the protection layer 30 for which the cross dimensions of the surface portions 71 of the insulation layer 70 are reduced with consequent increase of the cross dimensions of the third openings 72. It thus follows that the surface portions 71 of the insulation layer 70 are pulled back with respect to their initial position, in the direction indicated by the arrows in figure 8.

Clearly, in this etching step of the insulation layer 70 also surface portions of the insulation layer 70 are removed.

In particular, after this etching step of the insulation layer 70, the side walls of the third openings 72 between the surface portions 71 of the insulation layer 70 are at least vertical.

Advantageously, the side walls of the openings 72 are tapered downwards, i.e. the cross dimensions of the openings 72 decrease approaching the semiconductor substrate 100.

Advantageously, this etching step if of the isotropic type for example of the wet type.

Advantageously, if the protection layer 30 is formed by one nitride layer the etching step of this layer comprises a solution of hydrofluoric acid (HF).

The lower portions 31 of the protection layer 30 are then completely removed together with the dielectric layer 20 so as to expose portions of the semiconductor substrate 100.

A further dielectric layer 80, for example of tunnel oxide, is then formed on the exposed surface of the semiconductor substrate 100.

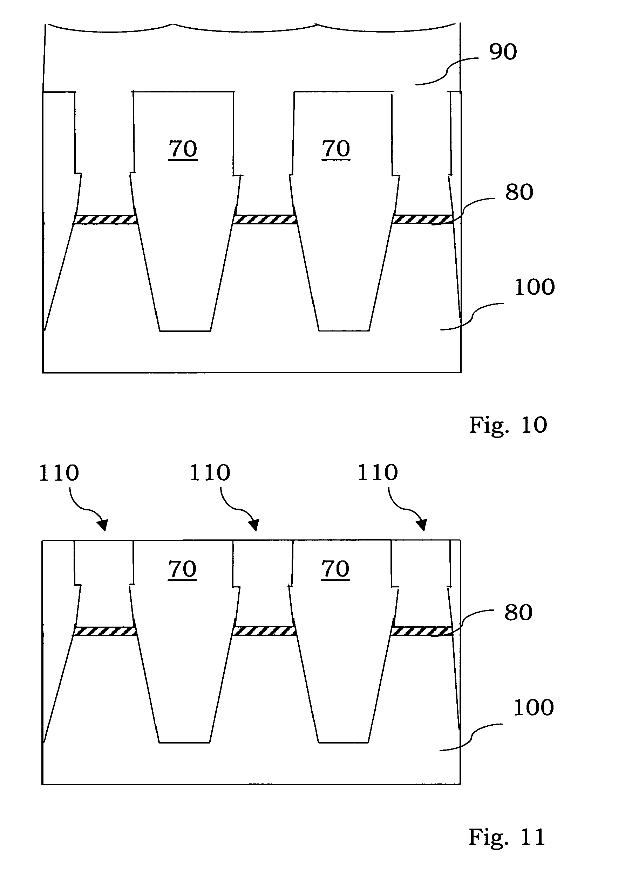

As shown in figure 10, a conductive layer 90, for example of polysilicon, is then formed on the whole device.

According to the invention, the polysilicon layer 90 completely fills in the third openings 72 without forming voids due to the profile of the third openings 72 which is vertical or tapered downwards.

In particular, if the side walls of the third openings 72 are tapered downwards, it is easier for the conductive layer 90 to fill in the third openings without forming voids as it occurs in the prior art.

The formation step of the polysilicon layer 90 is continued until the surface portions 71 of the insulation layer 70 are completely covered.

As shown in figure 11, a removal step of the polysilicon layer 90 is made follow at least until the surface portions 71 of the insulation layer 70 are exposed, but it can also remove surface layers of the insulation layer. The portions of the polysilicon layer 90 remaining confined between the surface portions 71 of the insulation layer 70 form floating gate electrodes 110 of the Flash memory cells having width W.

This removal step of the polysilicon layer 90 is conventionally carried out by means of CMP (Chemical Mechanical Polishing).

The process is then completed in a conventional way with the deposition, on the whole device, of an interpoly dielectric layer and a polysilicon layer for the formation of the control electrodes of the memory cells.

In conclusion, the method according to the invention allows to form Flash memory cells without voids inside the floating gate electrodes, adding, to the conventional process flow, only two process steps which can be formed at low cost, without using to thermal treatments which could alter the thermal budget of the conventional manufacturing process and thus damage the tunnel oxide layer 80 of the cells, and without intervening on the manufacturing steps of the trenches 60 which are quite critical and difficult to be modified.

Although in the present description specific reference has been made to memory cells of the Flash type, the method according to the present invention can be advantageously applied to non volatile memory cells provided with floating gate electrodes.

## Claims

1. Method for manufacturing non volatile memory cells integrated on a semiconductor substrate (100), each one comprising a floating gate electrode (110), the method comprising the steps of:
- depositing at least one protective layer (30) on said semiconductor substrate (100),
- forming a first plurality of openings (40) in said protective layer (30),
- etching said semiconductor substrate (100) through said first plurality of openings (40) so as to form a plurality of trenches (60),
- filling in said plurality of trenches (60) and said first plurality of openings (40) by means of an insulation layer (70), and being **characterised in that** it comprises the following steps:
- etching surface portions of said protective layer (30) to form:
- surface portions (71) of said insulation layer (70) projecting from the semiconductor substrate (100) divided from each other by a second plurality of openings (72), and
- lower portions (31) of said protection layer (30) confined below said second plurality of openings (72),
- etching said insulation layer (70) to reduce the cross dimensions of said surface portions (71) of said insulation layer (70),
- removing said lower portions (31) of said protection layer (30) until said semiconductor substrate (100) is exposed.

2. Method according to claim 1 **characterised in that** it comprises the steps of:
- forming an insulation layer (80) on said exposed semiconductor substrate (100),
- forming a conductive layer (90) on the whole device, said conductive layer (90) filling in said second plurality of openings (72) so as to form said floating gate electrodes (110).

3. Method according to claim 2 **characterised in that** said formation step of said conductive layer (90) comprises the steps of:
- deposition of said conductive layer (90), said conductive layer (90) completely coating surface portions (71) of said insulation layer (70),
- removing, by means of CMP, a surface portion of said conductive layer (90) so as to expose at least surface portions (71) of said insulation layer (70).

4. Method according to claim 1 **characterised in that** said etching step of surface portions of said protective layer (30) forms said second plurality of openings (72) with vertical side walls.

5. Method according to claim 1 **characterised in that** said etching step of surface portions of said protective layer (30) forms said second plurality of openings (72) with the side walls tapered downwards.

6. Method according to claim 1 **characterised in that** a further dielectric layer (20) is formed on the semiconductor substrate (100) prior to the protective layer (30).

7. Method according to claim 6 **characterised in that** before forming said plurality of trenches (60), said further dielectric layer (20) is etched through said first plurality of openings (40) to form a third plurality of openings (50).

8. Method according to claim 1 **characterised in that** said protective layer (30) is formed by a material which is highly selective with respect to the one of said insulation layer (70).

9. Method according to claim 1 **characterised in that** said protective layer (30) is formed by a nitride layer and said insulation layer (70) is formed by a field oxide layer.

10. Method according to claim 9 **characterised in that** said etching step of surface portions of said nitride layer (30) is formed by means of a solution comprising phosphoric acid, and that said etching step of said field oxide layer is formed by means of a solution comprising hydrofluoric acid.

11. Method according to claim 1 **characterised in that** said memory cells are organised in matrix in a non volatile memory electronic device.
